# Europäisches Patentamt

**European Patent Office**

**Office européen des brevets**

(19)

(11) Publication number: **0 098 060**
**B1**

(12) **EUROPEAN PATENT SPECIFICATION**

(45) Date of publication of patent specification: **02.12.87**

(51) Int. Cl.⁴: **H 03 K 5/02**

(21) Application number: **83303289.9**

(22) Date of filing: **07.06.83**

(54) **Clock pulse generating circuit.**

(30) Priority: **30.06.82 JP 111532/82**

(43) Date of publication of application:
**11.01.84 Bulletin 84/02**

(45) Publication of the grant of the patent:
**02.12.87 Bulletin 87/49**

(84) Designated Contracting States:
**DE FR GB**

(56) References cited:
**DE-A-2 851 825**
**US-A-4 061 933**

**IBM TECHNICAL DISCLOSURE BULLETIN,**
**Vol.18, No.2, July 1975, NEW YORK (US), pages**
**467-468, M.CUKIER: "Push-pull circuit"**

(73) Proprietor: **FUJITSU LIMITED**
**1015, Kamikodanaka Nakahara-ku**
**Kawasaki-shi Kanagawa 211 (JP)**

(72) Inventor: **Baba, Fumio**
**Miyamaedaira Green-haitsu 48-303 430**
**Mukogaoka**
**Miyamae-ku Kawasaki-shi Kanagawa 213 (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

## Description

The present invention relates to a clock pulse generating circuit, more particularly to a clock pulse generating circuit which boosts the voltage level of an input clock pulse higher than the voltage level of a power source, thereby producing therefrom a boosted output clock pulse.

In usual semiconductor circuits driven by power sources, the signals appearing in the circuits cannot have voltage levels higher than that of the power sources. Along with recent improvements in characteristics of semiconductor circuits, however, a strong demand has arisen for some signals appearing in the circuit to have a higher voltage level than that of the power source.

For example, in a dynamic memory and the like, it has been proposed to raise the level of the signal to be applied to each word line higher than the power source voltage level, thus increasing the amplitude of current flowing from the selected memory cell to the corresponding bit line and enabling perfect read and write operations of data.

Generally speaking, this can be effected by means of a clock generating circuit which receives an input clock pulse and produces an output clock pulse having a voltage level higher than the power source voltage. The present invention concerns such a clock pulse generating circuit.

There are problems, however, with the prior art clock pulse generating circuit. First, it is not easy to drive the circuit with low power. Second, it is difficult to achieve high speed operation.

A clock pulse generating circuit for boosting the level of an input clock pulse comprises a first transistor and a second transistor both connected in series between a first voltage source and a second voltage source, and a bootstrap capacitor, one end of which is connected to an intermediate connecting point between the first and second transistors, the bootstrap capacitor being charged to a level nearly the same as the level of the first voltage source by turning on the first transistor and turning off the second transistor, the voltage level at the other end of the bootstrap capacitor being boosted or pulled down by an input clock pulse delayed by a delay circuit during the charging of the bootstrap capacitor, thereby producing at the one end of the bootstrap capacitor an output clock pulse having a voltage magnitude larger than the voltage difference between the first and second voltage sources.

According to this invention in such a clock pulse generating circuit the first transistor is made of a first channel type transistor and the second transistor is made of a second channel type transistor and a switch circuit is mounted in the clock pulse generating circuit for interconnecting the gate of the first transistor either to the gate of the second transistor or to the intermediate connecting point alternatively, the switch circuit being operative to connect the gate of the first transistor to the intermediate connecting point only during the time that the voltage level at the other end of the bootstrap capacitor is boosted or pulled down, and to connect the gate of the first transistor to the gate of the second transistor at other times.

A particular example of a clock pulse generating circuit in accordance with this invention will now be described and contrasted with the prior art with reference to the accompanying drawings; in which:—

Figure 1 is a circuit diagram of a prior clock pulse generating circuit;

Figure 2 is a circuit diagram of part of the clock pulse generating circuit according to the present invention;

Figure 3 is a circuit diagram of a clock pulse generating circuit according to the present invention;

Figure 4 is a waveform diagram illustrating the operation of the clock pulse generating circuit in accordance with this invention; and

Figure 5 is a detailed circuit diagram of the inverter and delay circuits used in the clock pulse generating circuit in accordance with this invention.

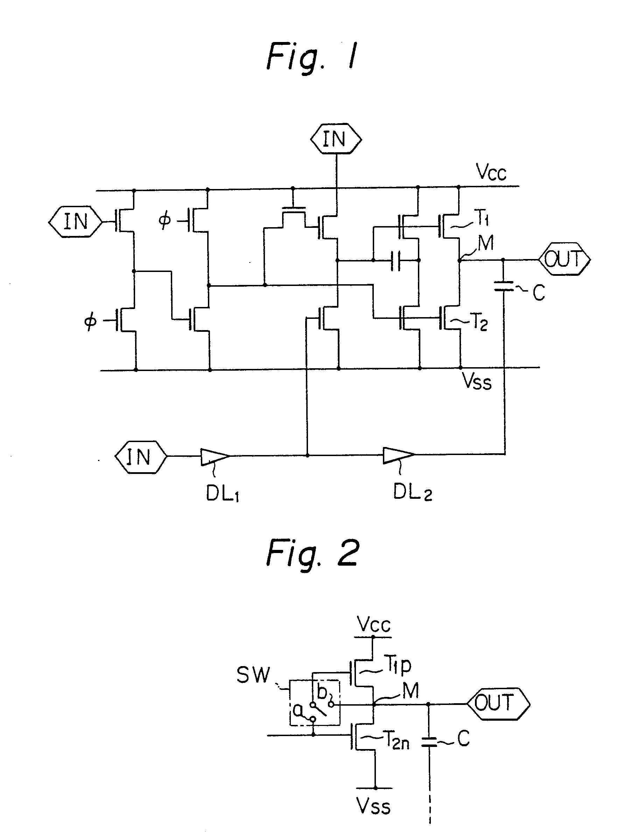

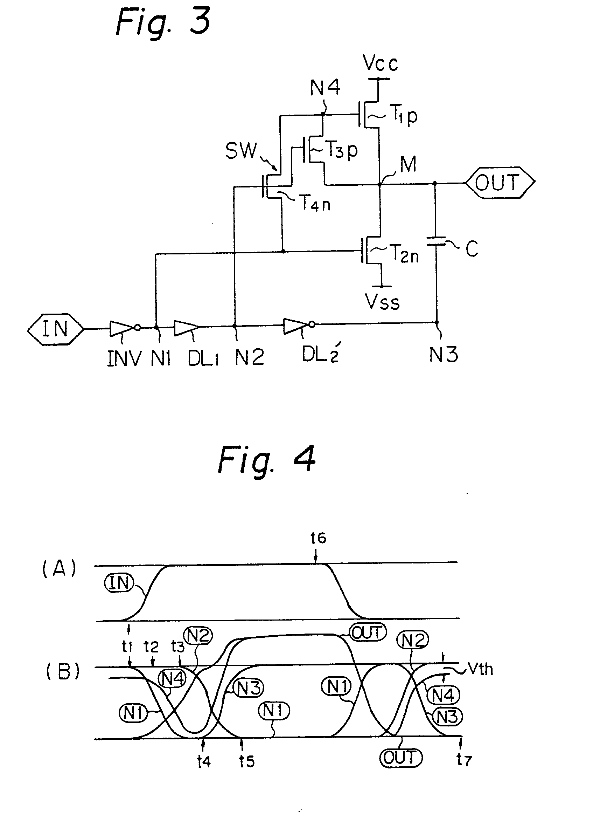

Before describing the preferred embodiments, a discussion will be made of a prior art clock generating circuit for reference purposes. Figure 1 is a circuit diagram of the prior art. Since the clock generating circuit of Figure 1 is well known, only a brief explanation of its operation will be given herein. A clock generating circuit similar to that of Fig. 1 is known by, for example US—A—4,061,933, especially illustrated in Fig. 3 thereof.

In Fig. 1, particular attention should be paid to first transistor $T_1$ and second transistor $T_2$ at the last stage of the circuit, which are connected in series between a first power source ($V_{cc}$) and a second power source ($V_{ss}$). An output OUT responding to an input clock IN is produced, with the aid of a bootstrap capacitor C, from an intermediate connecting point M between the first and second transistors $T_1$ and $T_2$. In this figure, the reference symbol $\phi$ denotes a precharging clock signal and $DL_1$ and $DL_2$ represent delay circuits.

During a certain time, the first transistor $T_1$ is on (the second transistor $T_2$ is off), and, therefore, the bootstrap capacitor is charged up to about the $V_{cc}$ level. Thereafter, the voltage level at the other end of the capacitor (C (one of terminals of the capacitor C, shown at the bottom side of the drawing) is boosted by the input clock IN (shown at the bottom side of the drawing) transferred to that end via the delay circuits $DL_1$ and $DL_2$. Then a voltage level higher than the $V_{cc}$ level can be obtained at one end (one of the terminals of the capacitor C shown at the top side of the drawing), which high voltage level output is the desired output clock OUT.

The above-mentioned clock generating circuit of the prior art and other clock generating circuits similar thereto of the prior art are usually comprised of single channel type transistors. That is, as seen from the circuit of Fig. 1, all the transistors are of the single channel type, i.e., n-channel and not p-channel. When all transistors are made of the same single channel type, DC current path are inevitably formed between the sources $V_{cc}$ and $V_{ss}$. These DC current path clearly are disadvantageous in terms of driving with low power. Further, looking at the first transistor $T_1$, since the source side is connected to the output of the circuit, the so-called substrate bias effect in the transistor $T_1$ becomes remarkable along with an increase of the voltage level at one end of the bootstrap capacitor C, resulting in a gradual increase in a threshold voltage $V_{th}$ of the transistor $T_1$. When the threshold voltage $V_{th}$ increases, the mutual conductance $g_m$ of the first transistor $T_1$ decreases. As a result, the current supplying capability of the transistor $T_1$ is reduced. This leads to a reduction of the operation speed.

Under such circumstances, one may first think of utilizing a C-MOS circuit so as to achieve driving with low power and to prevent a reduction of the current supplying capability. It is impossible, however, to simply replace the first and second transistors $T_1$ and $T_2$ of Fig. 1 with a C-MOS circuit for two reasons.

First, when utilizing a C-MOS circuit, the C-MOS circuit would be formed by a p-channel transistor $T_1$ and an n-channel transistor $T_2$, which transistors $T_1$ and $T_2$ may correspond to the first and second transistors $T_1$ and $T_2$, resepctively. In this case, it is not easy to turn off the p-channel transistor when the voltage level of the output clock exceeds the power source level. This is because a gate voltage of a level higher than the power source level is needed for the gate of the p-channel transistor when this transistor is to be turned off. Such a gate voltage is not obtainable in the circuit and must be supplied from outside the circuit.

Second, a new circuit must be employed for turning off both the p-channel and n-channel transistors after the output clock level exceeds the power source level. Although the use of a C-MOS circuit is not advantageous in view of the above mentioned two reasons, however, it should be noted, contrary to the above, that there is an advantage in that when a p-channel transistor is connected to the side of the power source $V_{cc}$, since the side of the p-channel transistor to be connected to the $V_{cc}$ side is the source thereof, no substrate bias effect is induced. Accordingly, no increase of the threshold voltage $V_{th}$ occurs and there is the advantage that of no gradual reduction of the current supplying capability.

According to the present invention, the clock generating circuit is fabricated by utilizing C-MOS circuits without causing the aforementioned problems. That is, the p-channel transistor can be turned off without having to introduce a gate voltage higher than the power source level. Also, both the p-channel and n-channel transistors can be turned off simultaneously without having to employ a new certain circuit. Thus, the present invention provides a clock generating circuit which effectively enables driving with low power and prevents reduction of the current supplying capability.

Figure 2 is a circuit diagram briefly illustrating the most important part of the clock generating circuit according to the present invention. In the figure, the first power source $V_{cc}$, the second power source $V_{ss}$, the bootstrap capacitor C, the output clock OUT and the intermediate connecting point M are substantially the same as those of Fig. 1. However, the first transistor $T_1$ and the second transistor $T_2$ of Fig. 2 are modified to a p-channel first transitor $T_{1p}$ and an n-channel second transistor $T_{2n}$, respectively, which are arranged in the form of a C-MOS circuit.

The previously mentioned switch circuit is represented by reference characters SW. The switch circuit SW is provided with contacts a and b. Under usual operation, the contact a is closed. Therefore, a usual C-MOS circuit is formed by the transistors $T_{1p}$ and $T_{2n}$. Once the voltage level of the output clock OUT exceeds the level of the power source $V_{cc}$, the contact b is closed (contact a is placed off). Thus, the high voltage appearing at the drain side of the p-channel transistor $T_{1p}$ is transferred, via the contact b now on, to its gate, whereby turning off the transistor $T_{1p}$. It should be noted that the p-channel transistor $T_{1p}$ can be turned off without having to apply to its gate an external voltage higher than the level of the power source $V_{cc}$.

The reason why the transistor $T_{1p}$ must be turned off after the level of the output clock OUT increases over the power source level is that if it were left on, the level of the output clock OUT would no longer be higher than the level of the power source $V_{cc}$. This is because, if the transistor $T_{1p}$ is still on, the level of the output clock will be equalized to the same level of $V_{cc}$ through the conductive transistor $T_{1p}$ as soon as the clock level exceeds the $V_{cc}$ level.

The above also applies to the second transistor $T_{2n}$ located at the second power source ($V_{ss}$) side. Thus, the transistor $T_{2n}$ must also be turned off, i.e., both the first transistor $T_{1p}$ and the second transistor $T_{2n}$ must be off. Therefore the voltage level of about the second power source $V_{ss}$ must be applied to the gate of the transistor $T_{2n}$.

As clear from the above explanations with reference to Fig. 2, first, under usual operation, the first and second transistors $T_{1p}$ and $T_{2n}$ form a C-MOS circuit (contact "a" closed) and driving with low power can be achieved.

Second, during a term other than that in which the usual operation is conducted, that is, when the level of the output clock OUT is increased over the level of the power source $V_{cc}$, both the first and second transistors $T_{1p}$ and $T_{2n}$ can be off simultaneously.

Third, in this case, the first transistor $T_{1p}$ can be turned off, not by applying an external voltage higher than $V_{cc}$ to its gate, but by commonly using the increased voltage of the output clock OUT itself.

Fourth, since the first transistor (the transistor to be connected to the power source side of $V_{cc}$) is a p-channel transistor, its source is connected to the $V_{cc}$. Accordingly, since the aforesaid substrate bias effect is not induced, the threshold voltage $V_{th}$ does not increase. This means that an overdrive between the gate source of the p-channel transistor can easily be performed, and therefore, the current supplying capacity of the output clock OUT can be made large. This results in an increase of the operation speed.

In conclusion, the clock genrating circuit of the present invention exhibits at least the above-mentioned four functions which are not exhibited in the prior art clock generating circuit.

Figure 3 is a circuit diagram of a clock generating circuit according to an embodiment of the present invention. In Fig. 3, a p-channel third transistor $T_{3p}$ and an n-channel fourth transistor $T_{4n}$ form a specific structure for realizing the switch circuit SW shown in Fig. 2. The remaining structure is substantially the same as that explained before.

The operation of the clock generating circuit will be explained with reference to the waveforms of Fig. 4. First, the input clock IN rises in level at the time t1 as shown by a curve IN of row (A). The inpout clock IN then falls in level, via an inverter INV, as shown by a curve N1 of row (B). The characters N1 represent a voltage waveform appearing at a node N1. At this time, a voltage level at a node N2 is still maintained at the power source side level of $V_{cc}$ (explained hereinafter). Therefore, the fourth transistor $T_{4n}$ is on. through the conductive transistor $T_{4n}$, the voltage at the node N1 is transferred to a node N4, which voltage level is now falling to the power source side level of $V_{ss}$. Accordingly, the voltage level at the node N4 falls, after the time t2, as shown by a curve N4 of row (B).

Further, along with a fall in level at the node N1 and with a certain delay time by the delay circuit $DL_1$, the voltage level at the node N2 starts falling at the time t3 as shown by a curve N2 of row (B).

In accordance with the level changes mentioned above, the first transistor $T_{1p}$ is turned on and the second transistor $T_{2n}$ is turned off. Then, one end of the bootstrap capacitor C is charged up to the $V_{cc}$ level (refer to the rise of the output clock OUT as shown by a curve OUT of row (B) in Fig. 4 after the time t1). The above-mentioned level change between IN and OUT is currently established by usual C-MOS circuit.

During the term from the time t2 to t3, the voltage level at the node N4 falls. Also, the voltage level at the node N2 falls. Thereby, the third transistor $T_{3p}$ is turned on, while the fourth transistor $T_{4n}$ is turned off. (This corresponds to a state, in Fig. 2, where the contact "b" in the switch circuit SW is closed). Via the now on third tran-sistor $T_{3p}$, the charged voltage at the capacitor C is transferred to the node N4, which is represented by a rise of the curve N4 after the time t4 as shown in row (B). After the time t5, the voltages at the node N4 and the output clock OUT vary with the same voltage level with each other. Thus the level at the node N4 is pulled up to the $V_{cc}$ side, and accordingly, the first transistor $T_{1p}$ is turned off. Consequently, the second transistor $T_{2n}$, which has been off after the time t3, and the first transistor $T_{1p}$ are now both off.

On the other hand, the level at the node N3 rises, with a certain delay time by the delay circuit $DL_2'$ (this circuit has functions of both a delay and level inversion), after the time near t4, as shown by a curve N3 of row (B). The level rise at the node N3 boosts the level at the other end of the bootstrap capacitor C. As a result, the level of the output clock OUT is boosted higher than the level of the power source $V_{cc}$ (refer to the curve OUT of row (B), which starts rising near the time t4). Here, the desired output clock OUT having a voltage level higher than that of the input clock IN, is obtained.

The input clock IN falls after the time t6, while the level N1 at the node N1 rises and is maintained at the level of about $V_{cc}$. At this time, the second transistor $T_{2n}$ is turned on and discharges the capacitor C. Therefore, the level of the output clock OUT falls toward the $V_{ss}$. Following this, the level at the node N2 rises again with a certain delay time by the delay circuit $DL_2'$. Then, the fourth transistor $T_{4n}$ is turned on, while the third transistor $T_{3p}$ is turned off, which corresponds to a state, in Fig. 2, where the contact a is closed and usual C-MOS circuit operation is achieved.

At this time, due to the nonconductive third transistor $T_{3p}$ and the conductive fourth transistor $T_{4n}$, the node N4 is charged by a rise in level at the node N2. In this case, however, the charged level at the node N4 is reduced by the amount of the threshold voltage $V_{th}$ (refer to row (B) of Fig. 4) of the fourth transistor $T_{4n}$. Further, the level at the node N3 falls due to presence of the delay circuit $DL_2'$.

The state created after the time t7 in row (B) is equivalent to the state created after the time $t_1$, thus an identical operation is repeated thereafter.

In the above explanation, the voltage level at the other end of the bootstrap capacitor C is boosted and the output clock OUT becomes a level higher than the $V_{cc}$ level of the power source. This is also true of the opposite case. That is, when the voltage level at the other end of the bootstrap capacitor C is pulled down, an output clock OUT having a level lower than zero volt can be obtained. In this case, it is required to replace, the $V_{cc}$ level of the power source with the zero volt, the $V_{ss}$ level of the other power source with the $V_{cc}$ level, the p-channel transistors with n-channel transistors, and the n-channel transistors with p-channel transistors. Also, the waveform of the the input clock IN in row (A) should be transformed to a waveform which first falls from $V_{cc}$ to zero volt and then rises to $V_{cc}$ again.

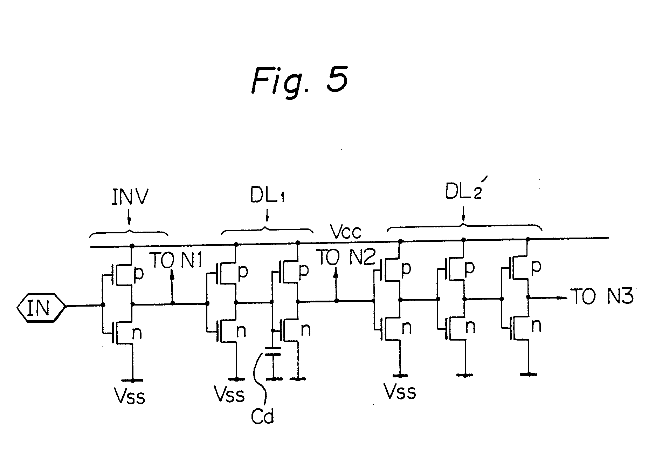

Figure 5 is a circuit diagram of a specific example of the inverter INV and the delay circuits $DL_1$ and $DL_2'$ shown in Fig. 4. As seen from this figure, these are basically a combination of C-MOS inverters. Corresponding portions are ref-erenced by INV, $DL_1$, and $DL_2'$. A delay capacitor $C_d$ in the circuit $DL_1$ may be used, if necessary.

Further, since the circuit $DL_2'$ has functions of not only a delay but also level inversion, it is composed of an odd number stage C-MOS inverter. In this figure, a three-stage C-MOS inverter is illustrated.

As explained above in detail, according to the present invention, a clock generating circuit is realized which is suitable for low power driving and which does not reduce the current supplying capability.

**Claims**

1. A clock pulse generating circuit, comprising: a first transistor ($T_{1p}$) and a second transistor ($T_{2n}$) both connected in series between a first voltage source ($V_{cc}$) and a second voltage source ($V_{ss}$), and a bootstrap capacitor (C), one end of which is connected to an intermediate connecting point (M) between the first and second transistors ($T_{1p}$ and $T_{2n}$), the bootstrap capacitor (C) being charged to a level nearly the same as the level of the first voltage source ($V_{cc}$) by turning on the first transistor ($T_{1p}$) and turning off the second transistor ($T_{2n}$), the voltage level at the other end of the bootstrap capacitor being boosted or pulled down by an input clock pulse delayed by a delay circuit (DL) during the charging of the bootstrap capacitor (C), thereby producing at the one end of the bootstrap capacitor (C) an output clock pulse having a voltage magnitude larger than the voltage difference between the first and second voltage sources ($V_{cc}$ and $V_{ss}$), characterised in that the first transistor is made of a first channel type transistor ($T_{1p}$) and the second transistor is made of a second channel type transistor ($T_{2n}$) and in that a switch circuit (SW) is mounted in the clock pulse generating circuit for interconnecting the gate of the first transistor ($T_{1p}$) either to the gate of the second transistor ($T_{2n}$) or to the intermediate connecting point (M) alternatively, the switch circuit (SW) being operative to connect the gate of the first transistor ($T_{1p}$) to the intermediate connecting point (M) only during the time that the voltage level at the other end of the bootstrap capacitor (C) is boosted or pulled down, and to connect the gate of the first transistor ($T_{1p}$) to the gate of the second transistor ($T_{2n}$) at other times.

2. A clock pulse generating circuit according to claim 1, wherein the switch circuit (SW) includes a third transistor ($T_{3n}$) of the first channel type and a fourth transistor ($T_{4n}$) of the second channel type, the third transistor ($T_{3p}$) being connected between the gate of the first transistor ($T_{1p}$) and the intermediate connecting point (M), the fourth transistor ($T_{4n}$) being connected between the gate of the first transistor ($T_{1p}$) and the gate of the second transistor ($T_{2n}$), the input clock pulse being applied to gates of the third and fourth transistors via a predetermined time delay circuit ($DL_1$).

3. A clock pulse generating circuit according to claim 2, wherein an inverter (INV), a first delay circuit ($DL_1$), and a second delay circuit ($DL_2'$) are connected in series between an input terminal (IN) for receiving the input clock pulse and the other end of the bootstrap capacitor (C), the inverter (INV) receiving the input clock pulse, the output of the inverter being applied to the gate of the second transistor ($T_{2n}$) and also to the gate of the first transistor ($T_{1p}$) via the fourth transistor ($T_{4n}$) and to an input of the first delay circuit ($DL_1$), the output of the first delay circuit ($DL_1$) being applied to the gates of both the third ($T_{3p}$) and fourth ($T_{4n}$) transistors and applied to an input of the second delay circuit $DL_2'$), the second delay circuit also performing a level inverting function, the output of the second delay circuit ($DL_2'$) being applied to the other end of the bootstrap capacitor (C).

4. A clock pulse generating circuit according to claim 3, wherein each of the inverter (INV), first delay circuit ($DL_1$) and second delay circuit ($DL_2'$) is constructed in the form of a C-MOS inverter comprising at least one pair of transistors (Figure 5) with one of the transistors in each pair being of the first channel type and the other being of the second channel type, the second delay circuit ($DL_2'$) with its level inverting function being formed with an odd number of C-MOS inverter stages.

5. A clock pulse generating circuit according to claim 4, wherein the first delay circuit ($DL_1$) includes a delay capacitor ($C_d$).

**Patentansprüche**

1. Taktimpulsgeneratorschaltung mit: einem ersten Transistor ($T_{1p}$) und einem zweiten Transistor ($T_{2n}$), die beide in Reihe zwischen einer ersten Spannungsquelle ($V_{cc}$) und einer zweiten Spannungsquelle ($V_{ss}$) verbunden sind, und einem Bootstrap-Kondensator (C), dessen eines Ende mit einem Zwischenverbindungspunkt (M) zwischen den ersten und zweiten Transistoren ($T_{1p}$ und $T_{2n}$) verbunden ist, wobei der Bootstrap-Kondensator (C), durch Einschalten des ersten Transistors ($T_{1p}$) und Ausschalten des zweiten Transistors ($T_{2n}$), auf einen Pegel aufgeladen wird, der nahezu derselbe wie der Pegel der ersten Spannungsquelle ($V_{cc}$) ist und der Spannungspegel des anderen Endes des Bootstrap-Kondensators durch einen Eingangstaktimpuls hochgeschoben oder heruntergezogen wird, der in einer Verzögerungsschaltung (DL) während des Aufladens des Bootstrap-Kondensators (C) verzögert wurde, wodurch an dem einem Ende des Bootstrap-Kondensators (C) ein Ausgangstaktimpuls erzeugt wird, der eine Spannungsgröße hat, die größer als die Spannungsdifferenz zwischen der ersten und zweiten Spannungsquelle ($V_{cc}$ und $V_{ss}$) ist, dadurch gekennzeichnet, daß der erste Transistor aus einem ersten Kanaltyptransistor ($T_{1p}$) und der zweite Transistor aus einem zweiten Kanaltyptransistor ($T_{2n}$) besteht und daß eine Schalterschaltung (SW) in der Taktimpulsgeneratorschaltung angeordnet ist, um das Gate des ersten Transistors ($T_{1p}$) entweder mit dem Gate des zweiten Transistors ($T_{2n}$) oder mit dem Zwischenverbindungspunkt (M) alternativ zu verbinden, wobei die Schalterschaltung (SW) betreibbar ist, um das Gate des ersten Transistors ($T_{1p}$) mit dem Zwischenverbindungspunkt (M) nur während der Zeit zu verbinden, während der der Sapnnungspegel an dem anderen Ende des Bootstrap-Kondensators (C) hochgeschoben oder heruntergezogen wird, und um zu anderen Zeiten das Gate des ersten Transistors ($T_{1p}$) mit dem Gate des zweiten Transistors ($T_{2n}$) zu verbinden.

2. Taktimpulsgeneratorschaltung nach Anspruch 1, bei der die Schalterschaltung (SW) einen dritten Transistor ($T_{3p}$) von dem ersten Kanaltyp und einen vierten Transistor ($T_{4n}$) von dem zweiten Kanaltyp umfaßt, der dritte Transistor ($T_{3p}$) zwischen dem Gate des ersten Transistors ($T_{1p}$) und dem Zwischenverbindungspunkt (M) verbunden ist, der vierte Transistor ($T_{4n}$) zwischen dem Gate des ersten Transistors ($T_{1p}$) und dem Gate des zweiten Transistors ($T_{2n}$) verbunden ist, und der Eingangstaktimpuls dem Gate des dritten und vierten Transistors über eine vorbestimmte Verzögerungsschaltung ($DL_1$) zugeführt wird.

3. Taktimpulsgeneratorschaltung nach Anspruch 2, bei dem ein Inverter (INV), eine erste Verzögerungsschaltung ($DL_1$) und eine zweite Verzögerungsschaltung ($DL_2'$) in Reihe zwischen einem Eingangsanschaluß (IN) zum Empfang des Eingangstaktimpulses und dem anderen Ende des Bootstrap-Kondensators (C) angeschlossen sind, der Inverter (INV) den Eingangstaktimpuls empfängt, der Ausgang des Inverters dem Gate des zweiten Transistors ($T_{2n}$) und auch dem Gate des ersten Transistors ($T_{1p}$) über den vierten Transistor ($T_{4n}$) und zu einem Eingang der ersten Verzögerungsschaltung ($DL_1$) zugeführt wird, der Ausgang der ersten Verzögerungsschaltung ($DL_1$) den Gates sowohl des dritten ($T_{3p}$) als auch des vierten ($T_{4n}$) Transistors und dem Eingang der zweiten Verzögerungsschaltung ($DL_2'$) zugeführt wird, die zweite Verzögerungsscahltung ebenfalls eine Pegelinverterfunktion durchführt, der Ausgang der zweiten Verzögerungsschaltung ($DL_2'$) dem anderen Ende des Bootstrap-Kondensators (C) zugeführt wird.

4. Taktimpulsgeneratorschaltung nach Anspruch 3, bei der jeder Inverter (INV) die erste Verzögerungsschaltung ($DL_1$) und zweite Verzögerungsschaltung ($DL_2'$) in Form eines C-MOS-Inverters aufgebaut sind, der wenigstens ein Paar von Transistoren (Figur 5) umfaßt, von denen ein Transistor in jedem Paar von dem ersten Kanaltyp und der andere von dem zweiten Kanaltyp ist, die zweite Verzögerungsschaltung ($DL_2'$) mit ihrer Pegelinvertierungsfunktion mit einer ungeraden Anzahl von C-MOS-Inverterstufen aufgebaut ist.

5. Taktimpulsgeneratorschaltung nach Anspruch 4, bei der die erste Verzögerungsschaltung ($DL_1$) einen Verzögerungskondensator ($C_d$) umfaßt.

**Revendications**

1. Circuit générateur d'impulsions d'horloge, comprenant: un premier transistor ($I_{1p}$) et un deuxième transistor ($T_{2n}$) connectés tous les deux en série entre une première source de tension ($V_{cc}$) et une deuxième source de tension ($V_{ss}$), et un condensateur d'amorçage (C) dont une extrémité est connectée à un point·de connexion intermédiaire (M) entre les premier et deuxième transistors ($I_{1p}$ et $T_{2n}$), le condensateur d'amorçage (C) étant chargé à un niveau peu près égal au niveau de la première source de tension ($V_{cc}$) en rendant conducteur le premier transistor ($T_{1p}$) et en bloquant le deuxième transistor ($I_{2n}$), le niveau de tension à l'autre extrémité du condensateur d'amorçage étant amplifié ou réduit par une impulsion d'horloge d'entrée retardée par un circuit à retard (DL) pendant la charge du condensteur d'amorçage (C), en produisant ainsi à l'extrémité du condensateur d'amorçage (C) une impulsion d'horloge de sortie ayant une amplitude de tension supérieure à la différence de tension entre celles des première et deuxième sources de tension ($V_{cc}$ et $V_{ss}$), caractérisé en ce que le premier transistor est constitué par un transistor à premier type de canal ($T_{1p}$) et le deuxième transistor est constitué par un transistor à second type de canal ($T_{2n}$), et en ce qu'un circuit de commutation (SW) est monté dans le circuit générateur d'impulsions d'horloge pour interconnecter la grille du premier transistor ($T_{1p}$) à la grille du deuxième transistor ($T_{2n}$) ou au point de connexion intermédiaire (M) alternativement, le circuit de commutation (SW) étant actif pour connecter la grille du premier transistor ($T_{1p}$) au point de connexion intermédiaire (M) uniquement pendant le temps où le niveau de tension à l'autre extrémité du condensateur d'amorçage (C) est amplifié ou réduit, et pour connecter la grille du premier transistor ($T_{1p}$) à la grille du deuxième transistor ($T_{2n}$) à tout autre moment.

2. Circuit générateur d'impulsions d'horloge selon la revendication 1, dans lequel le circuit de commutation (SW) comprend un troisième transistor ($T_{3n}$) au premier type de canal et un quatrième transistor ($T_{4n}$) au second type de canal, le troisième transistor ($T_{3p}$) étant connecté entre la grille du premier transistor ($T_{1p}$) et le point de connexion intermédiaire (M), le quatrième transistor ($T_{4n}$) étant connecté entre la grille du premier transistor ($T_{1p}$) et la grille du deuxième transistor ($T_{2n}$), l'impulsion d'horloge d'entrée étant appliquée aux grilles des troisième et quatrième transistors par l'intermédiaire d'un circuit à retard de temps prédéterminé ($DL_1$).

3. Circuit générateur d'impulsions d'horloge selon la revendication 2, dans lequel un inverseur (INV), un premier circuit à retard ($DL_1$), et un second circuit à retard ($DL_2'$) sont connectés en série entre une borne d'entrée (IN) servant à recevoir l'impulsion d'horloge d'entrée et l'autre extrémité du condensateur d'amorçage (C), l'inverseur (INV) recevant l'impulsion d'horloge d'entrée, le signal de sortie de l'inverseur étant appliqué à la grille du deuxième transistor ($T_{2n}$) et également à la grille du premier transistor ($T_{1p}$) par l'intermédiaire du quatrième transistor ($T_{4n}$) et à une entrée du premier circuit à retard ($DL_1$), le

signal de sortie du premier circuit à retard (DL$_1$) étant appliqué aux grilles à la fois du troisième (T$_{3p}$) et du quatrième transistor (T$_{4n}$) et appliqué à une entrée du second circuit à retard (DL$_2$'), le second circuit à retard exécutant également une fonction d'inversion de niveau, le signal de sortie du second circuit à retard (DL$_2$') étant appliqué à l'autre extrémité du condensateur d'amorçage (C).

4. Circuit générateur d'impulsions d'horloge selon la revendication 3, dans lequel chacun parmi l'inverseur (INV), le premier circuit à retard (DL$_1$) et le second circuit à retard (DL$_2$') est construit sous la forme d'un inverseur à métal-oxyde-semiconducteur à symétrie complémentaire C-MOS comprenant au moins une paire de transistors (Figure 5), un des transistors de chaque paire ayant le premier type de canal et l'autre ayant le second type de canal, le second circuit à retard (DL$_2$') avec sa fonction d'inversion de niveau étant constitué d'un nombre impair d'étages d'inverseur C-MOS.

5. Circuit générateur d'impulsions d'horloge selon la revendication 4, dans lequel le premier circuit à retard (DL$_1$) comprend un condensateur à retard (C$_d$).

# Fig. 1

# Fig. 2

# Fig. 3

# Fig. 4

## Fig. 5